# EUROPEAN PATENT SPECIFICATION

(11) **EP 3 884 548 B1**
(45) Date of publication and mention of the grant of the patent: **01.01.2025**
(21) Application number: 19801055.5
(22) Date of filing: 14.11.2019
(51) Int. Cl.: H01S 5/10, G01S 7/481, G01S 7/486, H01S 5/183, H01S 5/30, H01S 5/42

(54) **TIME-OF-FLIGHT LIGHT SOURCE, TIME-OF-FLIGHT IMAGING SENSOR, TIME-OF-FLIGHT DEVICE AND METHOD**
FLUGZEITLICHTQUELLE, FLUGZEITBILDGEBUNGSSENSOR, FLUGZEITVORRICHTUNG UND -VERFAHREN
SOURCE DE LUMIÈRE POUR TEMPS DE VOL, CAPTEUR D'IMAGERIE POUR TEMPS DE VOL, DISPOSITIF DE TEMPS DE VOL ET PROCÉDÉ

(30) Priority: 22.11.2018 EP 18207692
(43) Date of publication of application: 29.09.2021
(73) Proprietor: Sony Semiconductor Solutions Corporation, Atsugi-shi, Kanagawa 243-0014 (JP); Sony Depthsensing Solutions SA/NV, 1160 Auderghem (Brussels) (BE)
(72) Inventor: BELMONTE PALMERO, Carlos, 70327 Stuttgart (DE)
(74) Representative: MFG Patentanwälte Meyer-Wildhagen Meggle-Freund Gerhard PartG mbB
(86) International application number: PCT/EP2019/081380
(87) International publication number: WO 2020/104296

(56) References cited:
- CARLOS BELMONTE ET AL: "Optimization of electrically tunable VCSEL with intracavity nematic liquid crystal", OPTICS EXPRESS, vol. 23, no. 12, 15 June 2015 (2015-06-15), US, pages 15706, XP055668916, ISSN: 2161-2072, DOI: 10.1364/OE.23.015706
- PANAJOTOV K ET AL: "Hybrid VCSEL: liquid crystal systems", PROCEEDINGS OF SPIE/ IS & T,, vol. 9381, 4 March 2015 (2015-03-04), pages 93810P - 93810P, XP060050527, ISBN: 978-1-62841-730-2, DOI: 10.1117/12.2079032
- MORINAGA MIZUKI ET AL: "VCSEL Amplifier Dot Projector with Folded-Path Slow-Light Waveguide for 3D Depth Sensing", 2018 IEEE INTERNATIONAL SEMICONDUCTOR LASER CONFERENCE (ISLC), IEEE, 16 September 2018 (2018-09-16), pages 1 - 2, XP033434249, DOI: 10.1109/ISLC.2018.8516183
- NIELS QUACK ET AL: "Development of a FMCW LADAR Source Chip Using MEMS-Electronic-Photonic Heterogeneous Integration", 13 March 2014 (2014-03-13), XP055399846, Retrieved from the Internet <URL:http://bsac.berkeley.edu/publications/search/send_publication_pdf2client.php?pubID=1394733773> [retrieved on 20170821]
- LAFOREST TIMOTHÉ ET AL: "Co-integration of a smart CMOS image sensor and a spatial light modulator for real-time optical phase modulation", PROCEEDINGS OF SPIE/ IS & T, IEEE, US, vol. 9022, 4 March 2014 (2014-03-04), pages 90220N - 90220N, XP060035796, ISBN: 978-1-62841-730-2, DOI: 10.1117/12.2039867
- I C KHOO ET AL: "Extremely nonlinear photosensitive liquid crystals for image sensing and sensor protection References and links", WORLD SCIENTIFIC OPT. LETT. PHYS. REV. A JPN. J. APPL. PHYS. APPL. OPT. J. APPL. PHYS. J. OPT. SOC. AM. B, 1 January 1993 (1993-01-01), pages 253 - 255, XP055700852, Retrieved from the Internet <URL:https://www.osapublishing.org/DirectPDFAccess/D6D1D51D-EF19-ED66-11AABB4D1DB206EB_63401/oe-4-11-432.pdf?da=1&id=63401&seq=0&mobile=no>
- MCCAMLEY MAUREEN ET AL: "Detection of alignment changes at the open surface of a confined nematic liquid crystal sensor", JOURNAL OF APPLIED PHYSICS, AMERICAN INSTITUTE OF PHYSICS, US, vol. 105, no. 12, 17 June 2009 (2009-06-17), pages 123504 - 123504, XP012125668, ISSN: 0021-8979, DOI: 10.1063/1.3148861

## Description

### TECHNICAL FIELD

The present disclosure generally pertains to a time-of-flight device and a method for controlling such a time-of-flight device.

### TECHNICAL BACKGROUND

Generally, time-of-flight (ToF) devices are known, which are used for determining a distance to or a depth map of a region of interest.

Typically, a ToF (time-of-flight) camera has, e.g., an illumination unit, optical parts, such as a lens system and an optical band-pass filter, and an image sensor, etc. The optical band-pass filter, typically, passes the light having the same wavelength as the light emitted by the illumination unit. Moreover, it is known that a ToF camera may use a specific wavelengths, e.g. 850 nm or 940 nm.

Although there exist techniques for a time-of-flight device to use a specific wavelength range, it is generally desirable to provide a time-of-flight device and a method for controlling such a time-of-flight device.

MORINAGA MIZUKI ET AL: "VCSEL Amplifier Dot Projector with Folded-Path Slow-Light Waveguide for 3D Depth Sensing", 2018 IEEE INTERNATIONAL SEMICONDUCTOR LASER CONFERENCE (ISLC), IEEE, 16 September 2018 (2018-09-16), pages 1-2, pertains to a VCSEL amplifier with folded-path slow-light waveguide layout that offers dot projection without extra optics by scanning wavelength.

Niels Quack ET AL: "Development of a FMCW LADAR Source Chip Using MEMS-Electronic-Photonic Heterogeneous Integration" 13 March 2014, pertains to an integrated Frequency Modulated Continuous Wave (FMCW) Laser Detection and Ranging (LADAR) source, combining tunable VCSELs with silicon photonic components and high performance CMOS integrated electronics, used for mobile 3D imaging, autonomous vehicles, 3D cartography or gesture based computing.

### SUMMARY

According to a first aspect, the present invention provides a time-of-flight device in accordance with independent claim 1.

According to a second aspect, the present invention provides a time-of-flight method in accordance with independent claim 15.

Further aspects are set forth in the dependent claims, the following description and the drawings.

### BRIEF DESCRIPTION OF THE DRAWINGS

Embodiments are explained by way of example with respect to the accompanying drawings, in which:
Fig. 1 illustrates a solar light spectrum;
Fig. 2 illustrates a silicon quantum efficiency for different operating wavelengths of a known ToF;
Fig. 3 illustrates an example of an interference effect in a multi-camera or multi time-of-flight device situation;
Fig. 4 illustrates an example of a drift of an operating wavelength due to temperature variation;
Fig. 5 illustrates an embodiment of a ToF system;
Fig. 6 illustrates a cross-sectional side view of an embodiment of a light source for a ToF device including a vertical-cavity surface-emitting laser and a liquid crystal section;
Fig. 7 illustrates a cross-sectional side view of an embodiment of an imaging sensor for a ToF device including an imaging portion and a liquid crystal portion;
Fig. 8 illustrates a cross-sectional side view of an embodiment of a ToF light source including multiple vertical-cavity surface-emitting lasers and a liquid crystal section located within each of the multiple vertical-cavity surface-emitting lasers;
Fig. 9 illustrates a cross-sectional side view of another embodiment of a ToF light source including multiple vertical-cavity surface-emitting lasers and a liquid crystal section arranged on the multiple vertical-cavity surface-emitting lasers;
Fig. 10 illustrates a cross-sectional side view of an embodiment of a ToF device including a control configured to adjust the operating wavelength of the light source and the imaging sensor;
Fig. 11 illustrates a peak wavelength changing with different liquid crystal refractive indices; and
Fig. 12 is a flowchart of an embodiment of a method for controlling a ToF device.

### DETAILED DESCRIPTION OF EMBODIMENTS

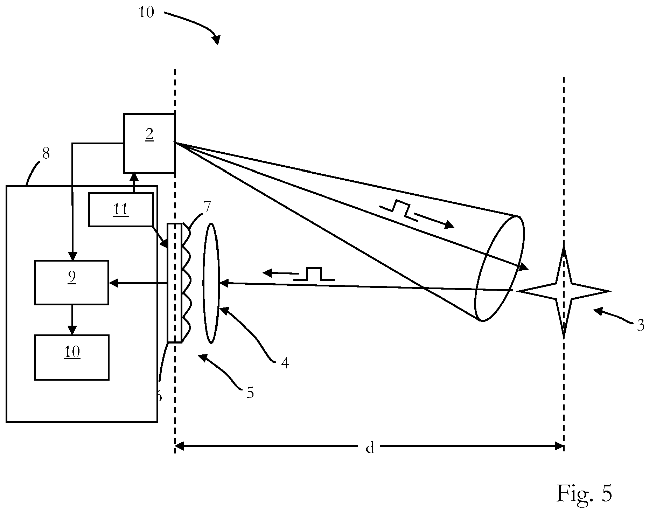

Before a detailed description of an embodiment of a ToF device under reference of Fig. 5 is given, some general explanations are made.

As mentioned in the outset, time-of-flight (ToF) devices (e.g. time-of-flight camera) typically have an illumination unit, such as a light source, optical parts, such as a lens system and an optical band-pass filter, and an image sensor, etc.

Generally it is known that the wavelength at which a time-of-flight device typically functions is in the near-infrared range (750 nm-1400 nm). However, in the near-infrared range, not all of the wavelengths provide a desirable operation efficiency for a ToF device. The efficiency of a ToF device at an operation wavelength typically depends on its noise tolerance when it comes to the solar spectrum power, on the quantum efficiency, and the like.

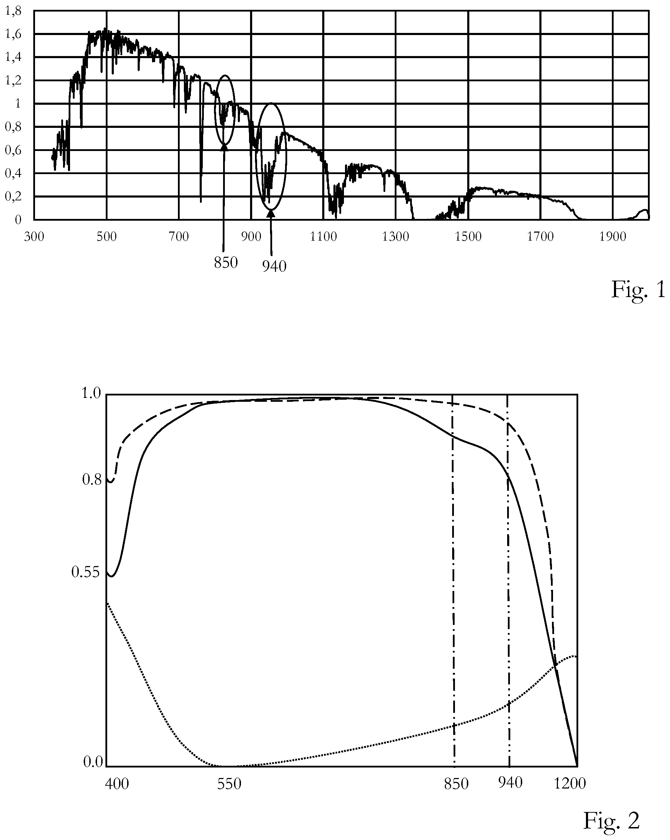

Fig. 1 illustrates a solar spectrum power for different operating wavelengths of a known time-of-flight device, wherein the abscissa represents wavelengths of the solar light in a range between 300 nm and 2000 nm and the ordinate represents an intensity parameter of the solar light. As can be taken from the Fig. 1, in the near-infrared range, there are two dips in the intensity in the solar light spectrum, namely at a wavelength of 850 nm and at a wavelength of 940 nm, which are therefore selected as operating wavelengths of a ToF device in some embodiments, since in these cases, in particular in outdoor situations, the ambient sun light intensity is expected to be small at these wavelengths (without limiting the present disclosure in that regard). Thus, in some embodiments, 850 nm and/or 940 nm may be selected as operating wavelength in outdoor situations where sun light is present. Furthermore, as also explained below, in some embodiments a quantum efficiency of an image sensor may be high at least in the range of 850 nm and, thus, may allow producing of the image sensor at low costs.

Moreover, Fig. 2 illustrates a silicon quantum efficiency of a time-of-flight device (i.e. its image sensor) for different operating wavelengths, wherein the abscissa represents different operating wavelengths of a time-of-flight device in a wavelength range between 400 nm and 1200 nm and the ordinate represents an associated silicon quantum efficiency of the time-of-flight device. The dotted curve represents the surface reflectance, the curve with interrupted lines represents the reference internal quantum efficiency, and the continuous curve represents the 6N Silicon material internal quantum efficiency. As can be taken from Fig. 2, in the near-infrared range, the operating wavelength at 850 nm corresponds to a silicon quantum efficiency of 0.9 and the operating wavelength at 940 nm corresponds to a silicon quantum efficiency of 0.8. In both cases, the silicon quantum efficiency is in an acceptable range, whereas at wavelengths greater than 940 nm, the silicon quantum efficiency reduces to values which are typically not acceptable.

As can also be taken from Fig. 2, for example, at a wavelength around 600 nm the silicon quantum efficiency is higher, but as this wavelength is in the visible range it is typically not used for time-of-flight devices (without limiting the present disclosure in that regard).

From the discussion above, it can be taken that operating wavelengths at 850 nm and at 940 nm provide a suitable compromise between noise caused by ambient sun light and silicon quantum efficiency.

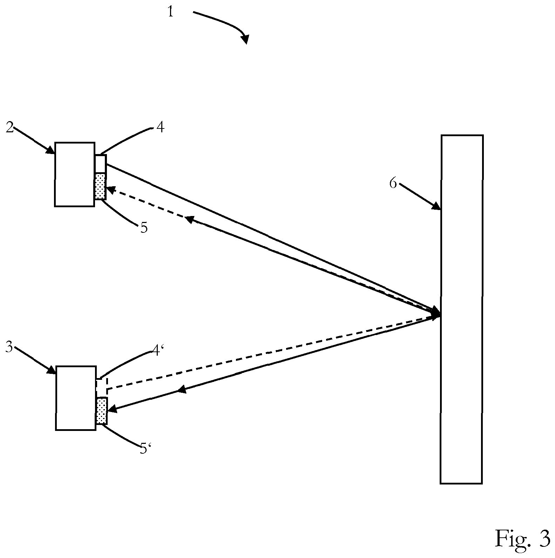

Moreover, generally, interferences in a multi time-of-flight device situation 1 may occur as is discussed under reference of Fig. 3. In this example, there are two time-of-flight devices 2 and 3 and each of the time-of-flight devices 2 and 3 has a vertical-cavity surface-emitting laser 4 and 4' and an imaging sensor 5 and 5', respectively. Both of the time-of-flight devices 2 and 3 illuminate the same scene 6 for performing a distance measurement, such that the time-of-flight device 2 receives the light signal (black interrupted line) emitted from the time-of-flight device 3 and, vice versa, the time-of flight device 3 receives the light signal (black continuous line) emitted from the time-of-flight device 2, which may result in a reduced accuracy of the measured distances, since the erroneously received light signals are used for determining the distance.

Generally, for addressing such an interference issue, several approaches are known, such as multiplexing, e.g. time-division multiplexing, code-division multiplexing or frequency-division multiplexing, which, however, typically require a complex circuitry for providing the multiplexing functionality.

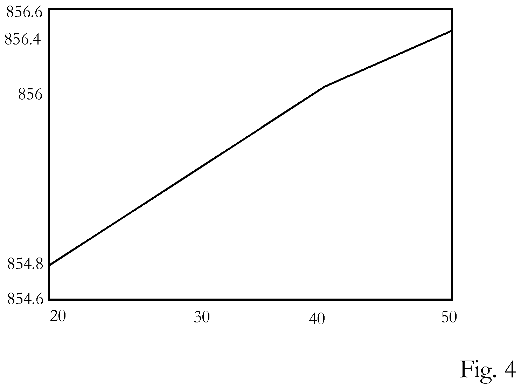

Moreover, generally, it is known that light sources, such as a vertical-cavity surface-emitting lasers (VCSEL), have a temperature dependency, such that the wavelength of the emitted light may change (drift) with temperature changes, such as also shown in Fig. 4, which illustrates a wavelength drift of a VCSEL of roughly two nanometers over a temperature range from 20 °C to 50 °C (ordinate shows the emitted wavelength and the abscissa the temperature of the VCSEL).

In such cases, it has been recognized that, when the wavelength drifts to other values, for example, the image sensor may have a different (reduced) quantum efficiency (see Fig. 2), the operating wavelength is in a different part of the solar spectrum (see Fig. 1), such that the intensity of the sun light at the operating wavelength may be increased, and, thus, the noise tolerance of the time-of-flight device may be different (e.g. reduced). Additionally, the efficiency of the time-of-flight device may be reduced, since the operating wavelength may change, while the filtering characteristic of the IR-band-pass filter of the image sensor remains the same, such that the light at operating wavelength may be (partially) filtered out by the IR-band-pass filter.

It has been recognized that at least one or more of the issues mentioned above, may be addressed by using a liquid crystal material for adjusting an operating wavelength of a ToF device (system or the like).

Consequently, some embodiments pertain to a light source for a time-of-flight device, including a vertical-cavity surface-emitting laser including a liquid crystal section for providing light generated by the vertical-cavity surface-emitting laser at two or more distant wavelengths.

The time-of-flight device may be a camera, may be included in another device, may be an apparatus or system or the like and the light source is adapted to function as a light source for a time-of-flight device.

Generally, the light source may be configured as a pulsed light source, a continuous light source or the like and it is based on a vertical-cavity surface-emitting laser (VCSEL). The term "laser" is understood functionally in some embodiments and the VCSEL may include multiple vertical-cavity surface-emitting lasing elements which together form the laser, i.e. the VCSEL. Hence, generally, explanations made for the VCSEL also apply to the single VCSEL elements of the VCSEL.

The light source of the time-of-flight device has a liquid crystal section, which may be located within the vertical-cavity surface-emitting laser. The liquid crystal section may be a nematic liquid crystal section based on known liquid crystal applications, such as liquid crystal lasers, liquid crystal thermometers, or the like.

In some embodiments, the nematic liquid crystal is a phase of a liquid crystal and the nematic liquid crystal may be a transparent liquid that causes the polarization of light waves to change as the light waves pass through the liquid. The extent of the change in polarization depends on the intensity of an applied voltage. When a voltage is applied, an electric field is produced in the liquid, which may affect the orientation of the molecules of the liquid.

By voltage application to the liquid crystal section of the time-of-flight light source, the light generated by the vertical-cavity surface-emitting laser may be provided at two or more distant wavelengths, since the liquid crystal section adapts the wavelength of the light accordingly. The ability to adjust the VCSEL wavelength may offer a further degree of freedom, such as choosing different wavelengths depending on the situation in which a ToF device is operated.

The at least two wavelengths are distinct to each other, such that there is a gap between the at least two wavelengths, where no light is emitted. In some embodiments, without limiting the present disclosure to this specific example, the two wavelengths are at (about) 850 nm and (about) 940 nm. As mentioned, these numbers are only given as an example, and in other embodiments any specific wavelength values may be used.

The vertical-cavity surface-emitting laser (and/or its elements) may be based on known vertical-cavity surface-emitting lasers to some extent, wherein in this disclosure the VCSEL light source includes the liquid crystal section.

The liquid crystal section may be located within the VCSEL and/or within its lasing elements, e.g. next to an active region where the light is generated, but it may also be located (at least partially) outside the VCSEL (and/or its lasing elements), such that light generated by the VCSEL passes through the liquid crystal section such that light is provided which is generated at least two distinct wavelengths. In other words, in some embodiments, the light which is emitted by the VCSEL itself may be generated at two or more distant wavelengths (wherein the liquid crystal section is within the VCSEL) or the light which is emitted by the VCSEL is passed through the liquid crystal section and thereby the light generated at two or more distinct wavelengths is provided, since the liquid crystal section is adjusted to the two or more distinct wavelengths.

Moreover, at least in some of the embodiments, the light is generated serially at two or more distant wavelengths, such that at a first point of time light is generated at a first wavelength, at a second point of time light is generated at a second wavelength, etc., wherein the first and second (or more) wavelengths are not generated and/or emitted in parallel.

In some embodiments, the vertical-cavity surface-emitting laser further has a top reflector part and a bottom reflector part, which may form a laser resonator. The liquid crystal section may be located between the top reflector part and the bottom reflector part, such that it can adapt the wavelength, e.g. in dependence of an applied voltage. The top reflector part and bottom reflector part may include or be made of distributed Bragg reflector (DBR) mirrors, which may be formed parallel to a wafer and/or to a substrate. The DBR-mirrors may have alternating layers with of a material having alternating high and low refractive indices. The DBR-mirrors or at least one of it may have an intensity reflectivity of about 99%. Also, the bottom reflector part may be located on the semiconductor substrate, for example a Si or GaAs substrate, which may provide a combination of high quantum efficiency and a low cost of production in some embodiments, or, e.g., an InP substrate, usually used in VCSEL, emitting at 1.3 µm and 1.55 µm, or the like, without limiting the present disclosure to this specific material. Hence, the top reflector part may emit the light and the bottom reflector part may be formed on a substrate.

In some embodiments, the vertical-cavity surface-emitting laser (and/or its elements) has an active section for generating the light. The active section may include AlGaInAs and may be pumped by an external light source with a shorter wavelength, for example another laser. The liquid crystal section may be located between the top reflector part and the active section, such that the light generated by the active section passes the liquid crystal section before being emitted through the top reflector part.

In some embodiments, the vertical-cavity surface-emitting laser (and/or its elements) of the time-of-flight light source further has an electrode and a current distributer. The current distributer may be configured to distribute current received from the electrode. The current may be uniformly distributed from the current distributer and afterwards the distributed current may be injected into the cavity of the VCSEL (and/or its elements). The VCSEL may include more than one current distributer and the one or more current distributers may be located between the active section and the bottom reflector part.

In some embodiments, the vertical-cavity surface-emitting laser (and or its elements) further has an injector. The injector may be configured to inject the distributed current, from the current distributer, into the active section. The current injector may be located adjacent to the current distributer.

In some embodiments, the vertical-cavity surface-emitting laser further has at least one spacer for adjusting tunnel junction. The at least one spacer may be located between the liquid crystal section and the active section. The current injected from the current injector may be injected into the tunnel junction.

In some embodiments, the vertical-cavity surface-emitting laser further has two tunnel junctions, into which the current injected. The two tunnel junctions may include AlGaInAs, wherein the one tunnel junction may be N-type and the other tunnel junction may be P-type. The two tunnel junctions may be at least partially surrounded by the spacer.

Furthermore, in some embodiments, the vertical-cavity surface-emitting laser further has at least one spreader for spreading the current injected by the current injector. The current may be injected into the tunnel junction and spread by the at least one spreader for preventing any filamentation of the lasing mode. The at least one spreader may be located between the liquid crystal section and the at least one spacer having the two tunnel junctions.

In some embodiments, the light source of the time-of-flight device includes multiple vertical-cavity surface-emitting lasers or laser elements, as discussed above, wherein each of the multiple vertical-cavity surface-emitting lasers or laser elements may have the structure of the above discussed vertical-cavity surface-emitting laser. Each of the multiple vertical-cavity surface-emitting lasers or laser elements may include a (nematic) liquid crystal section for providing light generated by the vertical-cavity surface-emitting laser at two or more distant wavelengths.

Some embodiments pertain to an imaging sensor for a time-of-flight device, having an imaging portion and a liquid crystal portion for transferring light at two or more distant wavelengths to the imaging portion.

The image sensor may be specifically designed for time-of-flight measurements and its imaging portion may be adapted to detect light emitted from the light source as described herein. The imaging portion (sensor) may be configured for direct ToF, where the time delay of the photons emitted by the light source and reflected by a scene are detected, it may be configured for indirect ToF, where basically a phase shift of the light emitted by the light source and reflected by a scene is detected, etc. The imaging portion may be based on at least one of the following: CMOS (complementary metal-oxide semiconductor), CCD (charge coupled device), SPAD (single photon avalanche diode), CAPD (current assisted photodiode) technology or the like.

The liquid crystal portion may be arranged on the imaging portion. In addition to the liquid crystal portion a band-pass filter, e.g. in the infrared or near infrared range, may be also arranged on the imaging portion with the liquid crystal portion (the band-pass filter may be arranged on top of the liquid crystal portion). Thereby, for example, the received light may be subject of a first filter step applied by the band-pass filter and a second (more narrow and/or accurate) filter step applied by the adjustable liquid-crystal band-pass filter for filtering the operating wavelength which falls into the imaging portion for detection and further processing.

In some embodiments, the liquid crystal portion may be configured as discussed for the light source and it may include or may be made of a nematic liquid crystal material, which may have the same characteristic as the nematic liquid crystal material of the liquid crystal section of the time-of-flight light source discussed herein. As mentioned, by (a suitable) voltage application to the liquid crystal portion of the time-of-flight imaging sensor, the liquid crystal portion transfers light at two or more distant wavelengths to the imaging portion.

Moreover, some embodiments pertain to a time-of-flight device, having a light source (as discussed herein), wherein the light source includes a vertical-cavity surface-emitting laser having a liquid crystal section for providing light generated by the vertical-cavity surface-emitting laser at two or more distant wavelengths; and an imaging sensor (as discussed herein), having an imaging portion and a liquid crystal portion for transferring light at two or more distant wavelengths to the imaging portion; and a control configured to adjust the operating wavelength of the light source and the imaging sensor.

The control may include one or more (microprocessors, field gate processors, memory, and other components which are typically implemented in an electronic control of a time-of-flight system/device/apparatus/camera.

The control may be configured in hardware and/or in software.

The control may adjust the operating wavelength of the light source and the imaging sensor by applying a corresponding voltage to the liquid crystal section and the liquid crystal portion, respectively, and/or by outputting a corresponding control signal to a supply voltage, which then in response to the control signal applies the associated voltage to the liquid crystal section and/or portion. The liquid crystal section of the light source may have the same or similar thickness and/or configuration as the liquid crystal portion of the imaging sensor, such that the voltage applied may be the same, making the time-of-flight device much less complex.

In some embodiments, the control adjusts the operating wavelength of the light source and/or the imaging sensor based on a predefined parameter. The predefined parameter may be indicative of an ambient light, the intensity of an ambient light, an ambient temperature, an operating wavelength of a light source of another time-of-flight device, or the like. Thereby it is possible, to operate the time-of flight device in accordance with and adapted to specific operation conditions represented, for example, by the predefined parameter, and to adapt to the operating wavelength of the light source and/or the imaging sensor accordingly.

The predefined parameter may be determined in advanced, it may be stored in the control, which may include a memory (e.g. an EEPROM or any other memory) for storing the predefined parameter, it may be determined dynamically, it may by derived on the basis of a sensor signal, etc.

In some embodiments, the time-of-flight device further includes a light sensor configured to detect an ambient light (e.g. the presence of ambient light, the intensity of ambient light, e.g. in dependence on a wavelength, a wavelength distribution, etc.). The predefined parameter may be indicative of the ambient light and the control may further adjust the operating wavelength, at two or more distant wavelengths, based on the detected ambient light. Generally, the functionality of a light sensor is known, and the disclosure is not limited to a specific light sensor. As discussed above, for example, in the case of present of the ambient light it may be useful to adapt the operating wavelength to 850 nm and/or 940 nm, for which the intensity of ambient light may be lower.

Moreover, in some embodiments, the time-of-flight device further includes a temperature sensor configured to detect an ambient temperature (of the light source and/or the imaging sensor and/or the device itself). The predefined parameter may be indicative of the ambient temperature and the control may further adjust the operating wavelength based on the detected ambient temperature, at two or more distant wavelengths. As discussed, for example, the wavelength emitted by the light source may have a certain temperature dependency which may dependent on the ambient temperature and, thus, by adjusting the wavelength accordingly a temperature drift of the light source may be compensated.

Some embodiments pertain to a time-of-flight method, which may be performed by the time-of-flight system or device as discussed herein. The method includes driving a light source (as discussed herein), including a vertical-cavity surface-emitting laser including a liquid crystal section for providing light generated by the vertical-cavity surface-emitting laser at two or more distant wavelengths; driving an imaging sensor (as discussed herein), including an imaging portion and a liquid crystal portion for transferring light at two or more distant wavelengths to the imaging portion; and adjusting the operating wavelength of the light source and the imaging sensor, as discussed herein also for the time-of-flight device/system.

As discussed, the operating wavelength may be adjusted based on a predefined parameter, which may be indicative of ambient light, ambient temperature, etc.

The time-of-flight method may detect an ambient light as the predefined parameter as discussed above, and adjust the operating wavelength by applying a corresponding voltage to the liquid crystal section and the liquid crystal portion, based on the detected ambient light, as discussed above.

Moreover, the time-of-flight method may detect an ambient temperature as the predefined parameter, and adjust the operating wavelength by applying a corresponding voltage to the liquid crystal section and the liquid crystal portion, based on the detected ambient temperature, as discussed above.

Furthermore, the time-of-flight method may detect a voltage (e.g. an operating voltage of the time-of-flight device, the light source, the image sensor, etc.), and adjust the operating wavelength by applying a corresponding voltage to the liquid crystal section and the liquid crystal portion, based on the detected voltage. Thereby, for example, the wavelength of the ToF device may be adapted to its operating voltage.

The ToF device may include corresponding circuitry for processing and analyzing the detection signals generated by the light source and the imaging sensor of the time-of-flight device and may be configured to control the time-of-flight device accordingly, wherein the circuitry may be part of the control or may include the control.

The ToF device may be formed based on a semiconductor and may be in any suitable manufacturing stage, such as on a wafer level, stacked semiconductor layers, may be in the form of or part of an electronic device including a housing or the like, may be included in another apparatus, etc.

Returning to Fig. 5, there is illustrated an example of a time-of-flight (ToF) system 1, which can be used for depth sensing or providing a distance measurement.

The ToF system 1 has a pulsed light source 2 and it includes light emitting elements, wherein in the present embodiment, the light emitting elements are vertical-cavity surface-emitting laser elements of a VCSEL as discussed herein.

The light source 2 emits pulsed light to an object 3 (region of interest), which reflects the light. By repeatedly emitting light to the object 3, the object 3 can be illuminated, as it is generally known to the skilled person. The reflected light is focused by an optical stack 4 to a light detector 5.

The light detector 5 has an image sensor 6, as discussed herein, which is in this embodiment implemented based on multiple SPADs (Single Photon Avalanche Diodes) and a microlens array 7, which focuses the light reflected from the object 3 to the image sensor 6.

The light emission time information is fed from the light source 2 to a circuitry 8 including a time-of-flight measurement unit 9, which also receives respective time information from the image sensor 6, when the light is detected which is reflected from the object 3. On the basis of the emission time information received from the light source 2 and the time of arrival information received from the image sensor 6, the time-of-flight measurement unit 9 computes a round-trip time of the light emitted from the light source 2 and reflected by the object 3 and on the basis thereon it computes a distance d (depth information) between the image sensor 6 and the object 3.

The depth information is fed from the time-of-flight measurement unit 9 to a 3D image reconstruction unit 10 of the circuitry 8, which reconstructs (generates) a 3D image of the object 3 based on the depth information received from the time-of-flight measurement unit 9.

Moreover, the ToF system 1 further has a control 11 (included in the circuitry 8) to adjust appropriately the operating wavelength after a voltage application (in other embodiment, the circuitry 8 may from the control as discussed herein).

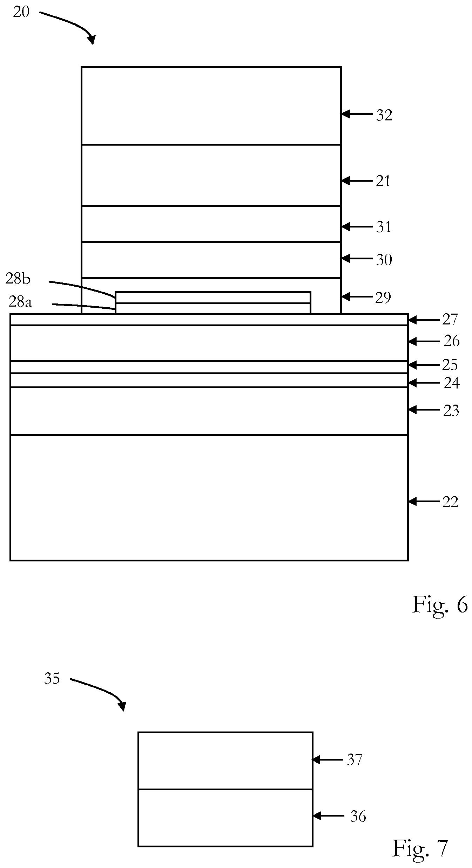

Fig. 6 illustrates a side view of the light source 20 for a ToF device (such as of Fig. 5) including a vertical-cavity surface-emitting laser 20 as light source including a liquid crystal section 21. In this embodiment, only one VCSEL element 20 is illustrated for simplification reasons, whereas the light source 20 may include multiple VSCSEL elements 20.

The vertical-cavity surface-emitting laser 20 has a liquid crystal section 21, which is located within the vertical-cavity surface-emitting laser 20. The vertical-cavity surface-emitting laser 20 has a bottom reflector part 22, which may include AlGaAs/GaAs, (lower side in Fig. 6), a current distributer 23, which may include InP, an injector 24, which may include GaInPAs, a current distributer 25, which may include InP, an active region 26, which may include AlGaInAs, a spacer 27, which may include, two tunnel junction 28a and 28b, which may include, a spacer 29, which may include InP, two spreader 30 and 31, which may include InP and a top reflector part 32, which may include Al-GaAs/GaAs, wherein the parts 22 to 32 are arranged on top of each other in the given order, wherein light is emitted in a vertical direction directed to the top in Fig. 6. (The materials given above are only examples and the present disclosure is not limited to theses specific materials.)

The liquid crystal section 21 is located between the top reflector part 32 and the bottom reflector part 22 (forming a laser resonator), which is located on a semiconductor substrate, for example Si or GaAs or the like (not shown). In more detail, the liquid crystal section 21 is located between the top reflector part 32 and the active section 26, which is configured to generate light.

The current distributer 23, which is located between the active section 26 and the bottom reflector part 22, has a current distribution function. The distributed current is injected into the active region 26 by the injector 24, which is located adjacent to the current distributer 23.

The two spacers 27 and 29 are provided for adjusting a tunnel junction, and they are located between the liquid crystal section 21 and the active region or section 26. The tunnel junction is provided by the two tunnel junctions 28a and 28b, which are located within the spacer 29, such that the spacer 29 surrounds (partially) the two tunnel junctions 28a and 28b. The current injected is spread by the two spreaders 30 and 31, which are located between the liquid crystal section 21 and the spacer 29 having the two tunnel junctions 28a and 28b.

Fig. 7 illustrates a side view of an imaging sensor 35 for a ToF device (e.g. of Fig. 5) including an imaging portion 36 and a liquid crystal portion 37.

The liquid crystal portion 37 of the imaging sensor 35 transfers light, to the imaging portion 37, at two or more distant wavelengths, wherein the imaging portion 36 is arranged on the liquid crystal portion 37. The liquid crystal portion 37 may have an IR-band-pass filter for filtering appropriately the wavelength of the incoming light.

The imaging portion 36 basically corresponds to the image sensor 6 of Fig. 5.

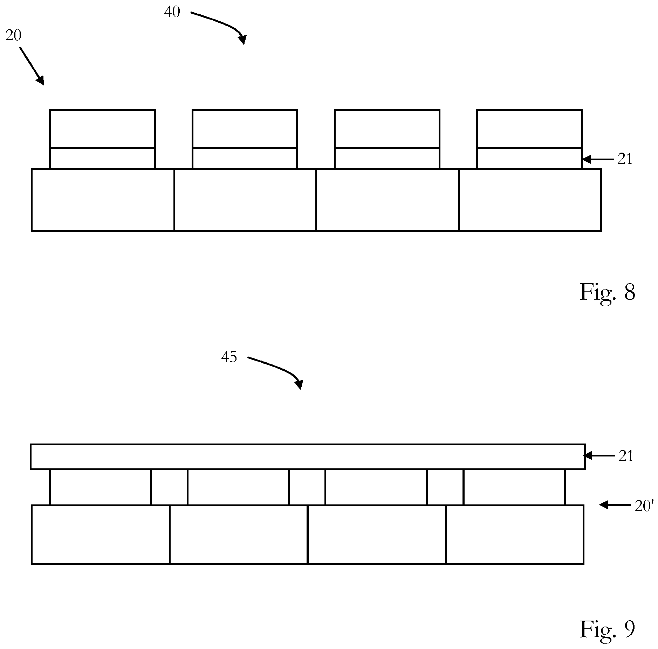

Figs. 8 and 9 illustrate two embodiments 40 and 45, each in a side view, of a light source 2, as discussed in Fig. 5, including each multiple vertical-cavity surface-emitting lasers and each the liquid crystal section 21.

In particular, in the embodiments of Fig. 8 and Fig. 9, the liquid crystal section 21 is located in two different locations with respect to a vertical-cavity surface-emitting lasers 20 and 20'.

In the embodiment 40 of Fig. 8 multiple vertical-cavity surface-emitting lasers 20 are provided each having the liquid crystal section 21 integrated in them, wherein the liquid crystal section 21 is located within each of the multiple vertical-cavity surface-emitting lasers 20, as discussed above for Fig. 6.

In the embodiment 45 of Fig. 9 multiple vertical-cavity surface-emitting lasers 20' are provided, however, here a common liquid crystal section 21 is provided which is arranged on top of the multiple vertical-cavity surface-emitting lasers 20'.

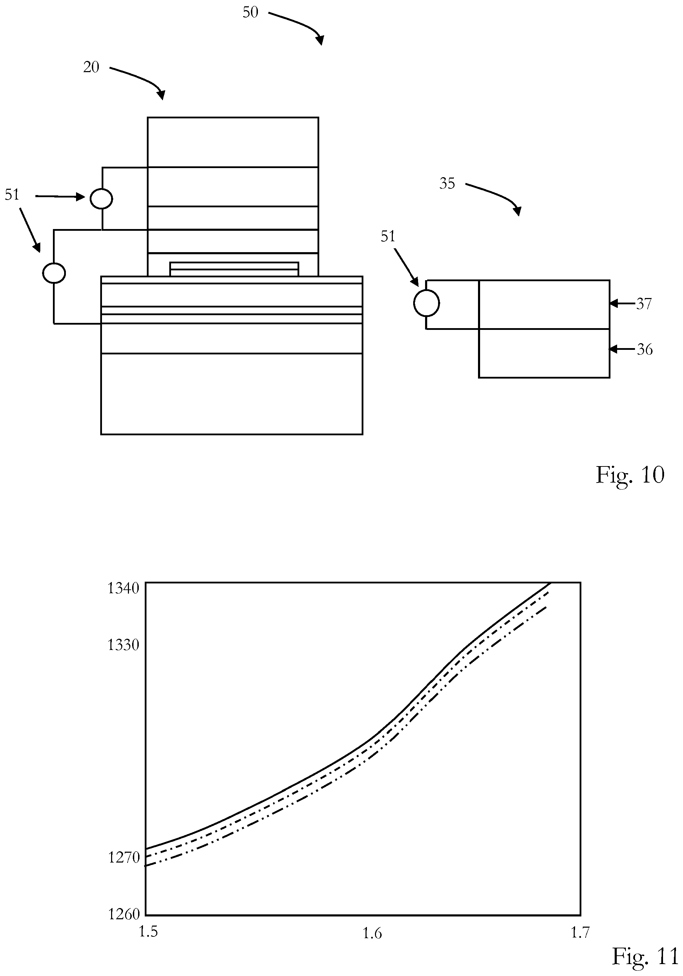

Fig. 10 illustrates a side view of an embodiment of a time-of-flight light device 50 having a control 51 (which may include in some embodiments, sub-controls, e.g. for the VCSEL(s) and for the light source) configured to adjust the operating wavelength of the light source 2 and the imaging sensor 35.

The time-of-flight light device 50 has a light source 2, which includes, as briefly described in Fig. 6, a vertical-cavity surface-emitting laser 20, including a liquid crystal section 21 for providing light generated by the vertical-cavity surface-emitting laser 20 at two or more distant wavelengths. Moreover, the time-of-flight light device 50 has an imaging sensor 35, which includes, as briefly described in Fig. 7, an imaging portion 36 and a liquid crystal portion 37 for transferring light at two or more distant wavelengths to the imaging portion 36. Furthermore, the time-of-flight light device 50 has a control 51 configured to adjust the operating wavelength of the light source 2 and the imaging sensor 35, wherein the control 51 has the same functions as the control 11 of Fig. 5. In Fig. 10 basically the connection points to the vertical-cavity surface-emitting laser 20 and the imaging sensor 35 are illustrated and are denoted as 51.

The operating wavelength may be controlled by applying a low voltage (0.5-1mV). In some embodiments, the applied voltage may be in a different range, e.g. 1-2V, and it may depend on the thickness of the liquid crystal and the controllable operation wavelength range. The low voltage is applied to the nematic liquid crystal section 21, which may be located within the VCSEL 20 and to the nematic liquid crystal portion 37, which may be located within the imaging sensor 35, as discussed herein.

The voltage application may cause rotation of the direction of the liquid-crystal molecules, and may change its refractive index, as illustrated in Fig. 11 showing the change of the peak wavelength (ordinate) with respect to the refractive index (abscissa). Hence, the operating wavelength in which the VCSEL is lasing can be adjusted based on the applied voltage.

Applying a suitable voltage to the liquid crystal material (section or portion) means that the suitable refractive index of the liquid crystal is selected, whereby the associated peak wavelength is adjusted. The reason is that the voltage application to the liquid crystal has the same effect as changing the refractive index of the liquid crystal.

Hence, the IR-band-pass filter discussed herein may include or may be formed of the liquid crystal portion 36 to control the operating wavelength of the imaging sensor 35 in concordance with the operating wavelength of the VCSEL 20 included in the light source 2.

Moreover, the operating wavelength of the time-of-flight device 50, and in particular the operating wavelength of the light source 2 (VCSEL 20) and the imaging sensor 35 is adjusted at two or more distant wavelengths, by a control 51, based on a predefined parameter.

The predefined parameter may be a predefined intensity of an ambient light and/or the predefined parameter may be a predefined ambient temperature and/or the predefined parameter may be a predefined voltage, etc.

In this regard, the time-of-flight device 50 of Fig. 10 may additionally include in some embodiments a light sensor for detecting the predefined parameter, namely the intensity of the ambient light. The control 51 is then configured to adjust the operating wavelength by applying a corresponding voltage to the liquid crystal section 21 and the liquid crystal portion 36, based on the detected ambient light being, e.g. different from a predefined ambient light intensity.

In the case that the predefined parameter is an ambient temperature, the time-of-flight device 50 may include in some embodiments a temperature sensor for detecting the ambient temperature. The control 51 is then configured to adjust the operating wavelength by applying a corresponding voltage to the liquid crystal section 21 and the liquid crystal portion 37, based on the detected ambient temperature being, e.g. greater or lower than a predefined ambient temperature.

In the case that the predefined parameter is a predefined voltage, the time-of-flight device 50 may detect an operation voltage, e.g. of the light source 2 and/or the imaging sensor 35 or the like in some embodiments, and the control 51 may then be configured to adjust the operating wavelength by applying a corresponding voltage to the liquid crystal section 21 and the liquid crystal portion 37, based on the detected voltage being greater, e.g., than a predefined voltage.

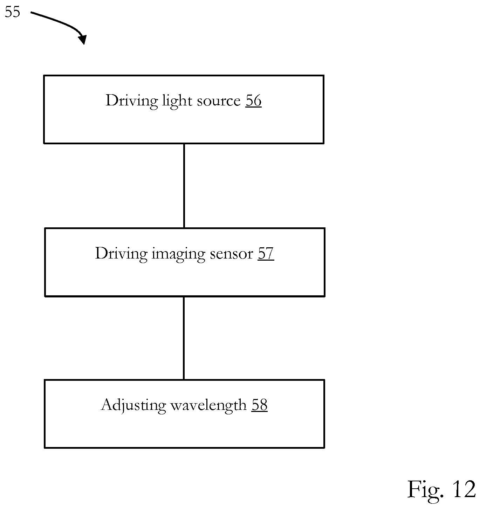

Fig. 12 is a flowchart of an embodiment of a time-of-flight method 55, which may be performed by a time-of-flight device, such as the time-of-flight device 10 of Fig. 5 and/or 50 of Fig. 10 discussed herein.

In the following, the method 55 is discussed based on the functions of the time-of-flight device 50 of Fig. 10 without limiting the present disclosure in that regard. Generally, the method 55 may be used for controlling a time-of-flight device, as discussed herein.

At 56, the light source 2 is driven by controlling a corresponding voltage application, wherein the voltage application causes the light source 2 to emit light generated by the vertical-cavity surface-emitting laser at two or more distant wavelengths, as discussed herein.

At 57, the imaging sensor 35 is driven by controlling a corresponding voltage application and read out of the imaging sensor 35, such that the liquid crystal portion transfers light at two or more distant wavelengths to the imaging portion, as discussed herein. As discussed, the adjusted operating wavelength of the imaging sensor 35 corresponds to the adjusted operating wavelength of the light source 2.

At 58, voltage application is such controlled or adjusted that the operating wavelength of the light source 2 and the imaging sensor 35 of the time-of-flight device 50 correspond to each other, as discussed herein. The adjustment of the voltage and the associated operation wavelength may be based on a predefined parameter, as discussed above.

As mentioned, the time-of-flight device 50 is able to function in two or more distant wavelengths by a low voltage application to the nematic liquid crystal section of the light source 2 and to the nematic liquid crystal portion of the imaging sensor. Hence, the time-of-flight device 50 is able to function at different environments, such as outdoors and indoors, based on adjusting the operation wavelength accordingly which is more suitable for outdoor (e.g. ambient light present) and indoor (e.g. no ambient light present). For instance, an operating wavelength at 850 nm is adjusted for an indoor environment and an operating wavelength of 940 nm is adjusted for an outdoor environment. The detection of an indoor or outdoor environment may be achieved, based on a light sensor, which may be including in the time-of-flight device 50 and which detects an ambient light, as discussed herein.

Hence, in such a scenario, the control 51 (or 11) may adjust the operating wavelength by applying a corresponding voltage to the liquid crystal section 21 and the liquid crystal portion 37, based on the detected ambient light and/or based on the detecting that an ambient light intensity is larger or smaller than a predefined ambient light intensity. For example, the time-of-flight device 50 may be set to operate at 850 nm in an indoor environment, low/no ambient light, when the light sensor detects an ambient light intensity smaller than 5 K lux, and to adjust the operating wavelength to 940 nm, which is appropriate for an outdoor environment, when the ambient light intensity is equal to or above 5 K lux (without limiting the present disclosure in that regard to this specific value). Different operation wavelengths may be set depending on the technology of the pixels, the properties of the IR-bandpass filter, the noise of the time-of-flight device 50, or the like.

By being able to adjust the operating wavelength of the time-of-flight device 50 at two or more distant wavelengths, depending of the environment requirements, the appropriate operating wavelength may be used within one time-of-flight device. In addition, the ability to adjust VCSEL wavelength may offer a degree of freedom, such as choosing different wavelengths depending on the situation in which a ToF device has to operate.

The above discussed time-of-flight device and time-of-flight method may also be applied in the know multi-camera scenario. In the multi-camera scenario multiple users with multiple cameras exist.

Generally, in the multi-camera scenario ToF technologies, it may happen that multiple time-of-flight cameras illuminating the same region of interest for performing distance or depth measurements, such that the measurements may cause interferences. For example, when two or more asynchronous ToF devices, i.e. cameras that are not sharing a coordination signal, try to obtain depth images of the same scene, they can experience crosstalk, i.e. the illumination of some cameras can interfere with the illumination of other cameras, which may introduce errors in the measurements, such as one camera could read the signal from another camera and give a wrong point cloud/depth map, as it is illustrated in Fig. 3, discussed above.

The time-of-flight device 50 is able to analyze the environment and detect if there is a ToF device working at the wavelength at default value, e.g. 850 nm, e.g. based on an additional light sensor or based on test measurement with the image sensor 35. In order to do that the time-of-flight device 50 is turned off, without lasing, but the image sensor 35 is driven. When another (interfering) ToF device is detect, the control 51 may apply a voltage to the liquid crystal section of the light source 2 and to the liquid crystal portion of the imaging sensor, thereby adjusting appropriately the operating wavelength which differs from the operating wavelength of the other ToF device.

Thus, the time-of-flight device operates in such a way without having interferences with the other ToF device and the time-of-flight device is able to select the operating wavelength that the entire time-of-flight device is sensitive to.

In view of the above, a time-of-flight device that is able to emit light at a stable operating wavelength is desirable and may be provided in some embodiments, since, for example, the time-of-flight device 50 is able to adjust its operating wavelength in two or more distant wavelengths by a low voltage application to the nematic liquid crystal section of the light source 2 and to the nematic liquid crystal portion of the imaging sensor, as discussed herein, based, for example, on a predefined parameter, such as a temperature or operating voltage.

Hence, the time-of-flight device 50 is able to overcome a temperature drift by adjusting appropriately the wavelength. As discussed, in some embodiments, a temperature sensor is arranged in the time-of-flight device 50, and the time-of-flight device 50 detects the ambient temperature. When the detected ambient temperature is, for example, larger or smaller than a predefined ambient temperature, a corresponding low or high voltage may be applied to both the liquid crystal section 21 and the liquid crystal portion 37, by the control 51. For example, a typical VCSEL has a temperature coefficient of around 0.1 nm per °C and the desirable wavelength (for example, 940nm.) is obtained at room temperature (25°C). If the detected ambient temperature is different than the room temperature a voltage may be applied into the liquid crystal section of the light source 2 and to the liquid crystal portion of the imaging sensor to adjust the operation wavelength of the time-of-flight device 50 at 940 nm.

Thus, such a time-of-flight device is able to emit light at a stable operating wavelength and may have at the same time an optimum efficiency.

The methods as described herein, in particular method 55, are also implemented in some embodiments as a computer program causing a computer and/or a processor to perform the method, when being carried out on the computer and/or processor. In some embodiments, also a non-transitory computer-readable recording medium is provided that stores therein a computer program product, which, when executed by a processor, such as the processor described above, causes the methods described herein to be performed.

It should be recognized that the embodiments describe methods with an exemplary ordering of method steps. The specific ordering of method steps is however given for illustrative purposes only and should not be construed as binding. For example the ordering of 56 and 57 in the embodiment of Fig. 8 may be exchanged. Other changes of the ordering of method steps may be apparent to the skilled person.

Please note that the division of the circuitry 8 into units 9 and 10 is only made for illustration purposes and that the present disclosure is not limited to any specific division of functions in specific units. For instance, the circuitry 8 could be implemented by a respective programmed processor, field programmable gate array (FPGA) and the like.

All units and entities described in this specification and claimed in the appended claims can, if not stated otherwise, be implemented as integrated circuit logic, for example on a chip, and functionality provided by such units and entities can, if not stated otherwise, be implemented by software.

In so far as the embodiments of the disclosure described above are implemented, at least in part, using software-controlled data processing apparatus, it will be appreciated that a computer program providing such software control and a transmission, storage or other medium by which such a computer program is provided are envisaged as aspects of the present disclosure.

## Claims

1. A time-of-flight device, comprising:
a light source (2; 20), including:
a vertical-cavity surface-emitting laser (20) including a liquid crystal section (21) configured to provide light generated by the vertical-cavity surface-emitting laser (20) at an operating wavelength adjustable to at least one of two or more distant wavelengths;
an imaging sensor (6; 35), including:
an imaging portion (36); and
a liquid crystal portion (37) configured to transfer light at the operating wavelength to the imaging portion (36); and
a control (11; 51) configured to adjust the operating wavelength of the light source (2; 20) and the imaging sensor (6; 35).

2. The time-of-flight device of claim 1, wherein the liquid crystal section (21) is located within the vertical-cavity surface-emitting laser (20).

3. The time-of-flight device of claim 2, wherein the vertical-cavity surface-emitting laser (20) further includes a top reflector part (32) and a bottom reflector part (22), wherein the liquid crystal section (21) is located between the top reflector part (32) and the bottom reflector part (22), in particular, wherein the vertical-cavity surface-emitting laser (20) further includes an active section (26) for generating the light, wherein the liquid crystal section (21) is located between the top reflector part (32) and the active section (26).

4. The time-of-flight device of claim 3, wherein the vertical-cavity surface-emitting laser (20) further includes a semiconductor substrate, wherein the bottom reflector part (22) is located on the semiconductor substrate.

5. The time-of-flight device of claim 4, wherein the vertical-cavity surface-emitting laser (20) further includes an electrode and a current distributer (23) configured to distribute current from the electrode, wherein the current distributer (23) is located between the active section (26) and the bottom reflector part (22).

6. The time-of-flight device of claim 5, wherein the vertical-cavity surface-emitting laser (20) further includes an injector (24) configured to inject a current into the active section (26), wherein the injector (24) is located adjacent to the current distributer (23).

7. The time-of-flight device of claim 6, wherein the vertical-cavity surface-emitting laser (20) further includes at least one spacer (27, 29) for adjusting a tunnel junction (28a, 28b), wherein the at least one spacer (27, 29) is located between the liquid crystal section (21) and the active section (26), in particular, wherein the vertical-cavity surface-emitting laser (20) further includes two tunnel junctions (28a, 28b), wherein the two tunnel junctions (28a, 28b) are at least partially surrounded by the at least one spacer (27, 29).

8. The time-of-flight device of claim 7, wherein the vertical-cavity surface-emitting laser (20) further includes at least one spreader (30, 31) for spreading the current injected, wherein the spreader (30, 31) is located between the liquid crystal section (21) and the at least one spacer (29).

9. The time-of-flight device of claim 1, wherein the liquid crystal section (21) is made of a nematic liquid crystal material.

10. The time-of-flight device of claim 1, wherein the liquid crystal portion (37) is arranged on the imaging portion (36).

11. The time-of-flight device of claim 10, wherein the liquid crystal portion (37) is made of a nematic liquid crystal material.

12. The time-of-flight device of claim 1, wherein the control (11; 51) is further configured to adjust the operating wavelength of the light source (2; 20) and the imaging sensor (6; 35) based on a predefined parameter.

13. The time-of-flight device of claim 12, further including:
a light sensor configured to detect an ambient light, wherein predefined parameter is indicative of the ambient light, or, a temperature sensor configured to detect an ambient temperature, wherein the predefined parameter is indicative of the ambient temperature.

14. The time-of-flight device of claim 12, wherein the predefined parameter is indicative of an operating wavelength of a light source of another time-of-flight device.

15. A time-of-flight method applied to the time-of-flight device according to claim 1, comprising:
driving a light source (2; 20) including a vertical-cavity surface-emitting laser (20) including a liquid crystal section (21) for providing light generated by the vertical-cavity surface-emitting laser (20) at two or more distant wavelengths,
driving an imaging sensor (6; 35) including an imaging portion (36), and a liquid crystal portion (37) for transferring light at two or more distant wavelengths to the imaging portion (36); and
adjusting the operating wavelength of the light source (2; 20) and the imaging sensor (6; 35).

## Patentansprüche

1. Laufzeitvorrichtung, umfassend:
eine Lichtquelle (2; 20), einschließend:
einen oberflächenemittierenden Laser mit vertikalem Hohlraum (20), der einen Flüssigkristallabschnitt (21) einschließt, der dazu konfiguriert ist, von dem oberflächenemittierenden Laser mit vertikalem Hohlraum (20) erzeugtes Licht bei einer Betriebswellenlänge bereitzustellen, die auf mindestens eine von zwei oder mehr weit auseinanderliegenden Wellenlängen einstellbar ist;
einen Bildgebungssensor (6; 35), einschließend:
einen Bildgebungsabschnitt (36); und
einen Flüssigkristallabschnitt (37), der dazu konfiguriert ist, Licht mit der Betriebswellenlänge an den Bildgebungsabschnitt (36) zu übertragen; und
eine Steuerung (11; 51), die zum Einstellen der Betriebswellenlänge der Lichtquelle (2; 20) und des Bildgebungssensors (6; 35) konfiguriert ist.

2. Laufzeitvorrichtung nach Anspruch 1, wobei sich der Flüssigkristallabschnitt (21) innerhalb des oberflächenemittierenden Lasers mit vertikalem Hohlraum (20) befindet.

3. Laufzeitvorrichtung nach Anspruch 2, wobei der oberflächenemittierende Laser mit vertikalem Hohlraum (20) ferner einen oberen Reflektorteil (32) und einen unteren Reflektorteil (22) einschließt, wobei sich der Flüssigkristallabschnitt (21) zwischen dem oberen Reflektorteil (32) und dem unteren Reflektorteil (22) befindet, insbesondere wobei der oberflächenemittierende Laser mit vertikalem Hohlraum (20) ferner einen aktiven Abschnitt (26) zum Erzeugen des Lichts einschließt, wobei sich der Flüssigkristallabschnitt (21) zwischen dem oberen Reflektorteil (32) und dem aktiven Abschnitt (26) befindet.

4. Laufzeitvorrichtung nach Anspruch 3, wobei der oberflächenemittierende Laser mit vertikalem Hohlraum (20) ferner ein Halbleitersubstrat einschließt, wobei sich der untere Reflektorteil (22) auf dem Halbleitersubstrat befindet.

5. Laufzeitvorrichtung nach Anspruch 4, wobei der oberflächenemittierende Laser mit vertikalem Hohlraum (20) ferner eine Elektrode und einen Stromverteiler (23) einschließt, der zum Verteilen von Strom von der Elektrode konfiguriert ist, wobei sich der Stromverteiler (23) zwischen dem aktiven Abschnitt (26) und dem unteren Reflektorteil (22) befindet.

6. Laufzeitvorrichtung nach Anspruch 5, wobei der oberflächenemittierende Laser mit vertikalem Hohlraum (20) ferner einen Injektor (24) einschließt, der dazu konfiguriert ist, einen Strom in den aktiven Abschnitt (26) einzuspeisen, wobei sich der Injektor (24) neben dem Stromverteiler (23) befindet.

7. Laufzeitvorrichtung nach Anspruch 6, wobei der oberflächenemittierende Laser mit vertikalem Hohlraum (20) ferner mindestens einen Abstandshalter (27, 29) zum Anpassen eines Tunnelübergangs (28a, 28b) einschließt, wobei sich der mindestens eine Abstandshalter (27, 29) zwischen dem Flüssigkristallabschnitt (21) und dem aktiven Abschnitt (26) befindet, insbesondere wobei der oberflächenemittierende Laser mit vertikalem Hohlraum (20) ferner zwei Tunnelübergänge (28a, 28b) einschließt, wobei die beiden Tunnelübergänge (28a, 28b) zumindest teilweise von dem mindestens einen Abstandshalter (27, 29) umgeben sind.

8. Laufzeitvorrichtung nach Anspruch 7, wobei der oberflächenemittierende Laser mit vertikalem Hohlraum (20) ferner mindestens einen Spreizer (30, 31) zum Verteilen des eingespeisten Stroms einschließt, wobei sich der Spreizer (30, 31) zwischen dem Flüssigkristallabschnitt (21) und dem mindestens einen Abstandshalter (29) befindet.

9. Laufzeitvorrichtung nach Anspruch 1, wobei der Flüssigkristallabschnitt (21) aus einem nematischen Flüssigkristallmaterial besteht.

10. Laufzeitvorrichtung nach Anspruch 1, wobei der Flüssigkristallabschnitt (37) auf dem Bildgebungsabschnitt (36) angeordnet ist.

11. Laufzeitvorrichtung nach Anspruch 10, wobei der Flüssigkristallabschnitt (37) aus einem nematischen Flüssigkristallmaterial besteht.

12. Laufzeitvorrichtung nach Anspruch 1, wobei die Steuerung (11; 51) ferner dazu konfiguriert ist, die Betriebswellenlänge der Lichtquelle (2; 20) und des Bildgebungssensors (6; 35) basierend auf einem vordefinierten Parameter einzustellen.

13. Laufzeitvorrichtung nach Anspruch 12, ferner einschließend:
einen Lichtsensor, der zum Erkennen eines Umgebungslichts konfiguriert ist, wobei ein vordefinierter Parameter das Umgebungslicht anzeigt, oder einen Temperatursensor, der zum Erkennen einer Umgebungstemperatur konfiguriert ist, wobei der vordefinierte Parameter die Umgebungstemperatur anzeigt.

14. Laufzeitvorrichtung nach Anspruch 12, wobei der vordefinierte Parameter eine Betriebswellenlänge einer Lichtquelle einer anderen Laufzeitvorrichtung anzeigt.

15. Laufzeitverfahren, das auf eine Laufzeitvorrichtung nach Anspruch 1 angewendet wird, umfassend:
Ansteuern einer Lichtquelle (2; 20), die einen oberflächenemittierenden Laser mit vertikalem Hohlraum (20) einschließt, der einen Flüssigkristallabschnitt (21) zum Bereitstellen von von dem oberflächenemittierenden Laser mit vertikalem Hohlraum (20) erzeugtem Licht bei zwei oder mehr weit auseinanderliegenden Wellenlängen einschließt,
Ansteuern eines Bildgebungssensors (6; 35), der einen Bildgebungsabschnitt (36) und einen Flüssigkristallabschnitt (37) einschließt, um Licht mit zwei oder mehr weit auseinanderliegenden Wellenlängen an den Bildgebungsabschnitt (36) zu übertragen; und
Anpassen der Betriebswellenlänge der Lichtquelle (2; 20) und des Bildgebungssensors (6; 35).

## Revendications

1. Dispositif de temps de vol comprenant :
une source de lumière (2 ; 20) comportant :
un laser à cavité verticale émettant en surface (20) comportant une section de cristaux liquides (21) conçue pour fournir de la lumière générée par le laser à cavité verticale émettant en surface (20) à une longueur d'onde de fonctionnement réglable à au moins une des deux longueurs d'onde éloignées ou plus ;
un capteur d'imagerie (6 ; 35) comportant :
une partie d'imagerie (36) ; et
une partie de cristaux liquides (37) conçue pour transférer la lumière à la longueur d'onde de fonctionnement vers la partie d'imagerie (36) ; et
une commande (11 ; 51) configurée pour régler la longueur d'onde de fonctionnement de la source lumineuse (2 ; 20) et le capteur d'imagerie (6 ; 35).

2. Dispositif de temps de vol selon la revendication 1, dans lequel la section de cristaux liquides (21) est située à l'intérieur du laser à cavité verticale émettant en surface (20).

3. Dispositif de temps de vol selon la revendication 2, dans lequel le laser à cavité verticale émettant en surface (20) comporte en outre une partie réflectrice supérieure (32) et une partie réflectrice inférieure (22), dans lequel la section de cristaux liquides (21) est située entre la partie réflectrice supérieure (32) et la partie réflectrice inférieure (22), en particulier, dans lequel le laser à cavité verticale émettant en surface (20) comporte en outre une section active (26) pour générer la lumière, dans lequel la section de cristaux liquides (21) est située entre la partie réflectrice supérieure (32) et la section active (26).

4. Dispositif de temps de vol selon la revendication 3, dans lequel le laser à cavité verticale émettant en surface (20) comporte en outre un substrat semi-conducteur, dans lequel la partie inférieure du réflecteur (22) est située sur le substrat semi-conducteur.

5. Dispositif de temps de vol selon la revendication 4, dans lequel le laser à cavité verticale émettant en surface (20) comporte en outre une électrode et un distributeur de courant (23) configuré pour distribuer le courant à partir de l'électrode, dans lequel le distributeur de courant (23) est situé entre la section active (26) et la partie inférieure du réflecteur (22).

6. Dispositif de temps de vol selon la revendication 5, dans lequel le laser à cavité verticale émettant en surface (20) comporte en outre un injecteur (24) configuré pour injecter un courant dans la section active (26), dans lequel l'injecteur (24) est situé à côté du distributeur de courant (23).

7. Dispositif de temps de vol selon la revendication 6, dans lequel le laser à cavité verticale émettant en surface (20) comporte en outre au moins un écarteur (27, 29) pour régler une jonction tunnel (28a, 28b), dans lequel l'au moins un écarteur (27, 29) est situé entre la section de cristaux liquides (21) et la section active (26), en particulier, dans lequel le laser à cavité verticale émettant en surface (20) comporte en outre deux jonctions tunnel (28a, 28b), dans lequel les deux jonctions tunnel (28a, 28b) sont au moins partiellement entourées par l'au moins un écarteur (27, 29).

8. Dispositif de temps de vol selon la revendication 7, dans lequel le laser à cavité verticale émettant en surface (20) comporte en outre au moins un dispositif de propagation (30, 31) pour propager le courant injecté, dans lequel le dispositif de propagation (30, 31) est situé entre la section de cristaux liquides (21) et au moins un écarteur (29).

9. Dispositif de temps de vol selon la revendication 1, dans lequel la section de cristaux liquides (21) est constituée d'un matériau à cristaux liquides nématiques.

10. Dispositif de temps de vol selon la revendication 1, dans lequel la partie de cristaux liquides (37) est disposée sur la partie d'imagerie (36).

11. Dispositif de temps de vol selon la revendication 10, dans lequel la partie de cristaux liquides (37) est constituée d'un matériau à cristaux liquides nématiques.

12. Dispositif de temps de vol selon la revendication 1, dans lequel la commande (11 ; 51) est en outre configuré pour régler la longueur d'onde de fonctionnement de la source lumineuse (2 ; 20) et le capteur d'imagerie (6 ; 35) sur la base d'un paramètre prédéfini.

13. Dispositif de temps de vol selon la revendication 12, comprenant en outre :
un capteur de lumière configuré pour détecter la lumière ambiante, dans lequel le paramètre prédéfini est une indication de la lumière ambiante, ou un capteur de température configuré pour détecter la température ambiante, dans lequel le paramètre prédéfini est une indication de la température ambiante.

14. Dispositif de temps de vol selon la revendication 12, dans lequel le paramètre prédéfini indique une longueur d'onde de fonctionnement d'une source lumineuse d'un autre dispositif de temps de vol.

15. Procédé de temps de vol appliqué au dispositif de temps de vol selon la revendication 1, comprenant :
l'entraînement d'une source de lumière (2 ; 20) comportant un laser à cavité verticale émettant en surface (20) comportant une section de cristaux liquides (21) pour fournir la lumière générée par le laser à cavité verticale émettant en surface (20) à deux longueurs d'onde éloignées ou plus,
l'entraînement d'un capteur d'imagerie (6 ; 35) comportant une partie d'imagerie (36) et une partie de cristaux liquides (37) pour transférer la lumière à deux longueurs d'onde éloignées ou plus à la partie d'imagerie (36) ; et
le réglage de la longueur d'onde de fonctionnement de la source lumineuse (2 ; 20) et le capteur d'imagerie (6 ; 35).
